Europäisches Patentamt

European Patent Office

Office européen des brevets

(11) Publication number: 0 212 520
A2

# EUROPEAN PATENT APPLICATION

(21) Application number: 86111057.5

(51) Int. Cl.⁴: G11C 17/00

(22) Date of filing: 08.08.86

(30) Priority: 09.08.85 JP 174152/85

(43) Date of publication of application:
04.03.87 Bulletin 87/10

(84) Designated Contracting States:
DE FR GB IT

(71) Applicant: HITACHI, LTD.
6, Kanda Surugadai 4-chome Chiyoda-ku
Tokyo 100(JP)
Applicant: HITACHI TOBU SEMICONDUCTOR
LTD.
15, Oh-aza Asahidai Moroyama-machi
Iruma-gun Saitama(JP)

(72) Inventor: Tokai, Tatsuo
1234-86, Nagase Moroyama-cho
Iruma-gun Saitama(JP)
Inventor: Abe, Akira
804-67, Higashiohya
Ohmiya-shi Saitama(JP)
Inventor: Mitsuishi, Tomokuni
28-5, Kinugaoka 1-chome
Hachiohji-shi Tokyo(JP)
Inventor: Takei, Ichiro
Shimizu dormitory 57-9, Shimizunagare
Urushigawa
Gosyogawara-shi Aomori(JP)

(74) Representative: Strehl, Schübel-Hopf,
Groening, Schulz
Widenmayerstrasse 17 Postfach 22 03 45
D-8000 München 22(DE)

(54) Data processing method.

(57) A data processing method for an electronic device having memory means (7) and a resin molding member (8) encapsulating the memory means (7) includes a step of storing data in the memory means (7) and a step of erasing the data stored in the memory means (7). The data erasing step includes X-ray irradiation treatment and heat-treatment.

# FIG. 1

6(X-RAY)

N₂ (OR AIR)

ROM WRITE

| X-RAYS IRRADIATION | HEAT TREATMENT | REWRITE |

# DATA PROCESSING METHOD

## BACKGROUND OF THE INVENTION

This invention relates to a data processing method which processes data stored in memory means of an electronic device having the memory means. More particularly, the present invention relates to a method of erasing data stored in non-volatile memory means such as EPROMs - (Erasable Programmable Read-Only Memories).

Data that are once stored in EPROM using MOSFETs (insulated gate field effect transistors) can be erased by irradiating ultraviolet rays to a chip through a window disposed on the main plane of a package. However, a ceramic package having the glass window is expensive to produce, and resin (plastic) package has been used to reduce the cost of production as typified by "HN482764P-3" produced by Hitachi, Ltd. Though this ROM can be produced at a low cost of production, its stored data cannot be erased by the irradiation of ultraviolet rays. This ROM is referred to as "OTP - (One Time Electrically Programmable) ROM". The most critical problem with ROMs of the data un erasable type is that sufficient reliability cannot be obtained at the final inspection step of the products. In other words, although the products are preferably shipped under the state where no data are written into the memories so that customers can freely write the data into them, reliability test such as data write characteristics cannot be made under such a state. Accordingly, it has been a customary practice to sample a predetermined number of products for each lot, to make actual read or write test for the samples and to discard all the products of the lot if any one of the samples proves to be defective, in order to improve the test reliability.

In other words, in order to guarantee the product reliability, all the products of the lot are regarded as being defective and are discarded, how many accepted products may be contained in the lot, simply because the extracted sample prove to be defective. In accordance with this test method, there is the possibility that a large number of accepted products are contained in the discarded lot, and this is a great loss to manufacturers of semiconductor devices.

One prior art example for solving this problem is disclosed in Japanese Patent Laid-Open No. 75496/1984. This prior art reference pertains to a data erasing apparatus for EPROM which is packaged in and sealed by a plastic molding material. This data erasing apparatus is characterized in that an optimum quantity of X-rays are irradiated to EPROM molded by the plastic molding material to erase the data of EPROM. The apparatus is equipped with a shutter for cutting off the X-rays to be irradiated to EPROM at the point of time when erasing of the data of EPROM is complete.

The inventors of the present invention made intensive studies on the development of technique which can reliably erase the data that are once written into ROMs which are completely sealed at the upper portion of the chip by an opaque molding member which is opaque to the ultraviolet rays, such as OTROMs, but do not have a complicated electrical erasing mechanism such as EEPROM, and can improve the device characteristics such as write characteristics and data retention characteristics. The present invention is completed on the basis of these studies.

## SUMMARY OF THE INVENTION

The studies of the present inventors have clarified the followings. In the case of a data erasing method relying solely upon the irradiation of X-rays, the data stored in the memory cells can be made to some extents, but the erasing characteristics are not entirely satisfactory. Re-write characteristics and data retention characteristics are not satisfactory, either. One of the causes may be attributed to the damage due to the irradiation of X-rays which damage is assumed to exist in the gate oxide film of the memory cell and in the interface between the gate oxide film and the silicon substrate of the memory cell. This damage may presumably develop when the hole (positive charge) of a hole-electron pair occurring in the gate oxide film and the silicon substrate of the memory cell due to the irradiation of the X-rays is trapped to the energy level of the gate oxide film or to the energy level in the boundary between the gate oxide film and the silicon substrate.

It is therefore an object of the present invention to provide data processing technique which can reliably erase the data of OTPROM or the like and can moreover improve the re-write characteristics and the data retention characteristics.

The following is a representative example of the inventions disclosed herein.

The data processing method in accordance with the present invention includes a step of storing data in memory means and a step of erasing the data stored in the memory means, wherein the data erasing step includes X-ray irradiation treatment and heat-treatment.

In other words, after the data storing step, X-rays having suitable energy are irradiated from outside the molding member and heat-treatment -(annealing) that has not been employed conventionally is effected. in order to reliably erase the data that are once written into the memory cell. - (Annealing may be effected simultaneously with the irradiation of the X-rays.)

The ray quality of the X-rays used for the X-ray irradiation and its irradiation time are closely related with the quantity of the resulting damage of the memory cell. Therefore, the present invention irradiates the X-rays having the quality for a radiation time such that the X-rays can transmit through the molding member but do not impart an excessive damage to the memory cell. Furthermore, in conjunction with heat-treatment (annealing) which is one of the most significant factors in the data processing method of the invention, the necessity of annealing, a suitable temperature range, an annealing time and an annealing atmosphere (e.g. humidity) will be described next.

(1) The ray quality of the X-rays used for the X-ray irradiation is preferably soft X-rays having the wavelength of above a few tenths nm in order to reliably erase the data but not to impart the excessive damage to the memory cell. The irradiation time is below 60 minutes in view of possible damage of the memory cell. With the suitable X-ray quality and irradiation time described above, suitable X-ray irradiation treatment is preferably effected by impinging electrons, that are accelerated at a voltage value of from 30 KeV to 40 KeV and a current value of from 30 mA to 40 mA, against a chromium (Cr) target and by irradiating the X-rays generated from the target for 10 to 25 minutes.

(2) In view of thermal breakdown of the resin package, heat-treatment described above is preferably effected at a temperature in the range of from 125°C to 220°C. The heating time is preferably at least 4 hours in order to improve the data retention characteristics. A relative humidity for the heat-treatment is from 40% to 50% and preferably from 10% to 20% in view of the moisture-proofness of the electronic device. The heat-treatment can be made economically in air, but is preferably carried out in a nonoxidizing atmosphere such as in an $N_2$ gas in order to prevent the oxidation of lead material of the electronic device.

In accordance with the present invention, even when the hole (positive charge) of the electron-hole pair occurring in the gate oxide film of the memory cell or in its silicon substrate is trapped to the energy level in the gate oxide film or to the energy level of the boundary between the gate oxide film and the silicon substrate (that is, even when the damage develops), the heat-treatment can neutralize the trapped positive charge by thermally excited electrons or can move it by the thermal energy. As a result, the adverse influences of the trapped positive charge do not develop in the memory cell, and the data retention characteristics and data re-write characteristics of the memory cell can be improved.

BRIEF DESCRIPTION OF THE DRAWINGS

Fig. 1 is a schematic view showing the outline of the present invention;

Fig. 2 is a system diagram of OTPROM;

Fig. 3 is a sectional view showing the device structure of a memory cell;

Fig. 4 is a diagram showing data erasing characteristics;

Fig. 5 is a flowchart of a final inspection step to which the present invention is applied;

Fig. 6 is a block diagram showing the construction of a single chip microcomputer;

Fig. 7 is a schematic view showing the outline of a through-processing apparatus to which the present invention is applied; and

Fig. 8 is a diagram showing the kinds of electromagnetic waves.

DESCRIPTION OF THE PREFERRED EMBODIMENTS

Embodiment 1

(1) Steps:

The data processing method of the present invention includes a data storing step of storing data in memory means of EPROM and a data erasing step of erasing the data stored in the memory means, and the data erasing step includes X-ray irradiation treatment and heat-treatment. The X-ray irradiation treatment and the heat-treatment can be carried out in the following two ways. Namely, the heat-treatment is effected after the X-ray irradiation treatment, and the former is effected simultaneously with the latter.

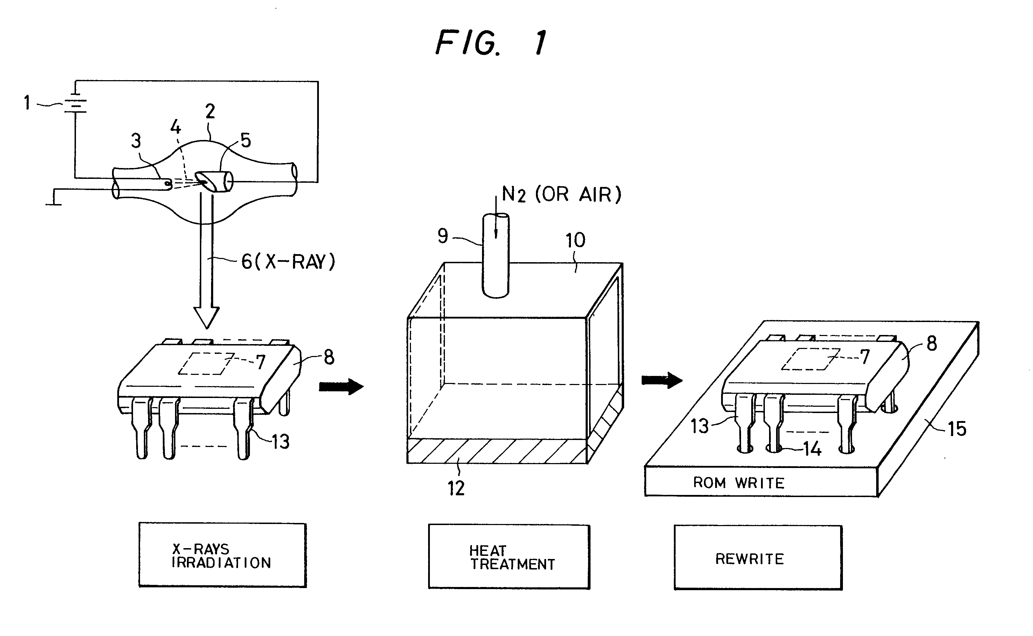

Next, an example of the data erasing step of the present invention will be described with reference to Fig. 1.

First of all, data are written into a semiconductor chip having memory means such as EPROM, and the X-rays 6 are then irradiated to a resin package 8 incorporating therein the chip 7 into which the data are written, as shown in the drawing. The X-rays are generated by impinging thermoelectrons from an electrode 3 against a target - (Cr) 5.

Next, the heat-treatment (annealing) is carried out in an annealing furnace the atmosphere of which is filled by hot air or with an inert gas such as an $N_2$ gas and which has a heat block 12 or the like. This annealing may be effected in a lamp annealing apparatus using a halogen lamp or an argon lamp. The relative humidity of the internal gas of the annealing furnace or the lamp annealing apparatus is such that a moisture reaches the chip 7 during annealing but aluminum wirings on the chip are not corroded by the entering moisture. (In other words, the relative humidity is such that the defect of moisture-proofness of the chip 7 can be prevented.) More definitely, the relative humidity is preferably below from 40% to 50%, and more preferably from below 10% to 20%. Although the annealing cost can be reduced by carrying out the annealing step in air, it is preferably carried out in an inert gas such as the $N_2$ gas (non-oxidizing atmosphere) in order to prevent oxidation of lead materials of IC.

The steps described above can erase the data that are once written into the memory means of the chip 7. Thereafter, the data are written once again - (re-written) into the memory means of the chip by use of an ROM writer 15.

(2) Data Erasing Mechanism:

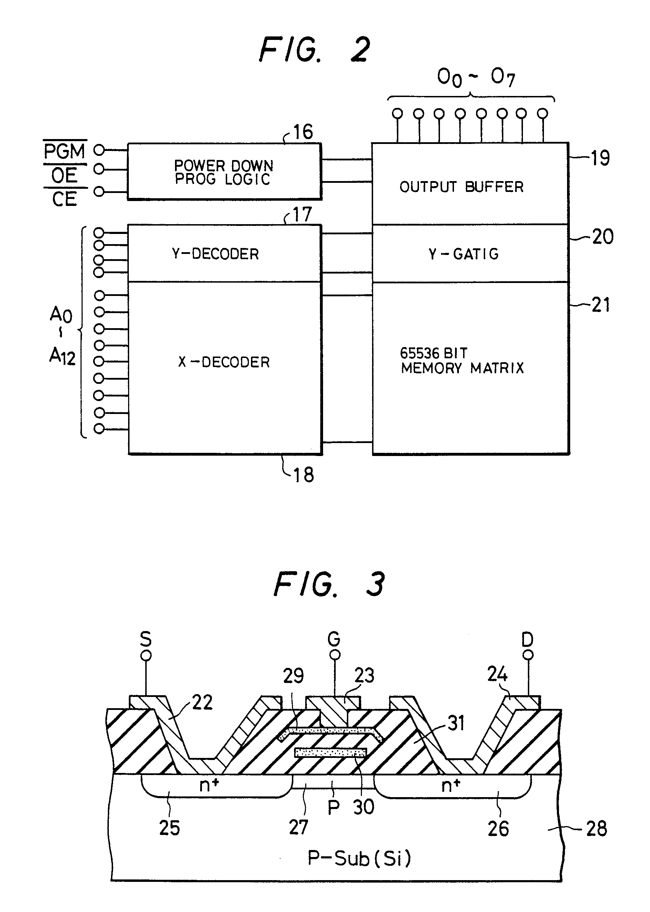

The chip 7 described above has a system construction such as shown in Fig. 2, for example. Namely, it comprises of a 64 K bit memory matrix 21, an X decoder 18, a Y decoder 17, a Y gate 20, an output buffer 19, and a program logic control circuit 16 for controlling a disenable or enable state, or the like. Each memory cell as the memory means that constitutes the memory matrix has a known laminated gate memory cell structure using a metal oxide semiconductor field effect transistor - (hereinafter called "MOSFET") such as shown in Fig. 3. Namely, an n-type source region 25 and an n-type drain region 26 are formed on a p-type substrate 28, and a p-type implantation layer 27 is disposed at a channel portion so as to adjust a threshold voltage to a predetermined value. A floating gate 30 and control gate 29 comprising of polycrystalline silicon are disposed on the main surface of the substrate 28 via an electrically insulating file 31 such as silicon dioxide ($SiO_2$), and metal electrodes 22, 23, 24 comprising of aluminum or the like are disposed further on the main surface of the substrate.

The data storing step into the memory cell of EPROM can be effected by applying a high voltage across a drain voltage 24 and a control gate 29. The high voltage of the drain region 26 raises the energy of the electrons at the channel portion, and the electrons turn into those electrons which have the energy capable of getting over the potential barrier of the gate oxide film (that is, so-called "hot electrons"). At this time, the hot electrons are attracted to the high voltage of the control gate and injected into the floating gate 30 so that the data can be stored in the memory cell of EPROM.

When the electrons are built up at the floating gate 30 of the memory cell, the threshold voltage of N-MOSFET becomes extremely high and a so-called "low (L) state" is established where the channel is not formed even when a negative potential is applied to the gate electrode (G) 23. On the other hand, when the electrons are not built up at the floating gate 30, the memory cell is under the state where the channel is formed and a so-called "high (H)" state is established. Accordingly, the data can be stored.

The data erasing mechanism in such a memory cell can be assumed as follows. In other words, since the X-rays have a high transmission effect of materials, they pass through the interior of the resin package and reach the floating gate 30. At this time the energy of the electrons built up at the floating gate 30 is excited by the energy of the X-rays, and the electrons turn again into the hot electons, jump over the oxide film and are absorbed by the control gate 29, or they jump over the gate oxide film and are absorbed by the substrate 28. As a result, the data of the memory cell are erased. The data erasure of the memory cell by the irradiation of the X-rays exceeding a certain energy value can be made within a certain range, but re-write of the data cannot be made directly in a stable way. (Its experimental result will be described elsewhere.) This results from the damage occurring in the memory cell due to the X-ray irradiation. It is believed that the hole of the hole-electron pair occurring inside the $SiO_2$ film and inside the silicon substrate 28 is firmly trapped to the energy level inside the $SiO_2$ film 31 or to the energy level of the boundary between the gate oxide film and the silicon substrate 28. Therefore, the value of the voltage applied to the control gate 29 at the time of re-writing the data into the memory cell is apparently reduced by the influences of the positive charge (hole) trapped inside the $SiO_2$ film and inside the boundary between the gate oxide film and the silicon substrate, so that the hot electrons cannot be injected into the floating gate 30 or the injection quantity of the hot electrons drops, thereby lowering the re-write characteristics. Furthermore, the data retention characteristics of the re-written data drop due to the influences of the hole trapped inside the $SiO_2$ film or in the boundary between the $SiO_2$ film 31 and the silicon substrate.

To recover the damage resulting from the X-ray irradiation, the electrons are injected by effecting annealing to cause thermal excitation so that the positive charge is neutralized or transferred by applying thereto the thermal energy. Data erasure for effecting stable re-writing can be made only after this step.

(3) Selection of X-ray Quality, Irradiation Energy, Annealing Condition, and the like:

The ray quality of the X-rays to be irradiated, the annealing condition, and the like, will be described in detail with reference to the experimental data obtained by the inventors of the present invention.

## Table 1

| Sample No. | erasing characteristics (Vcc min.nA) | leakage current | overall judgement |
|---|---|---|---|
| 1 | ○ ( 3.5 V ) | ○ ( 0.0 6 ㎂ ) | ○ |
| 2 | ○ ( 3.5 ) | ○ ( 0.0 6 ) | ○ |
| 3 | ○ ( 3.4 ) | ○ ( 0.0 6 ) | ○ |
| 4 | ○ ( 3.3 ) | ○ ( 0.0 6 ) | ○ |
| 5 | ○ ( 3.4 ) | ○ ( 0.0 6 ) | ○ |
| 6 | ○ ( 3.4 ) | ○ ( 0.0 6 ) | ○ |
| 7 | ○ ( 3.4 ) | ○ ( 0.0 6 ) | ○ |
| 8 | ○ ( 3.4 ) | ○ ( 0.0 6 ) | ○ |
| 9 | ○ ( 3.4 ) | ○ ( 0.0 6 ) | ○ |
| 1 0 | ○ ( 3.4 ) | ○ ( 0.0 6 ) | ○ |
| 1 1 | ○ ( 3.7 ) | ○ ( 0.3 6 ) | ○ |
| 1 2 | ✕ ( 4.0 ) | ✕ ( 1.0 6 ) | ✕ |
| 1 3 | ○ ( 3.7 ) | ○ ( 0.5 0 ) | ○ |
| 1 4 | ○ ( 3.7 ) | ○ ( 0.7 0 ) | ○ |
| 1 5 | ✕ ( 4.1 ) | ○ ( 0.5 4 ) | ✕ |
| 1 6 | ○ ( 3.7 ) | ○ ( 0.5 6 ) | ○ |
| 1 7 | ○ ( 3.6 ) | ○ ( 0.6 0 ) | ○ |
| 1 8 | ○ ( 3.6 ) | ○ ( 0.5 6 ) | ○ |
| 1 9 | ○ ( 3.7 ) | ○ ( 0.4 2 ) | ○ |
| 2 0 | ○ ( 3.6 ) | ○ ( 0.5 8 ) | ○ |

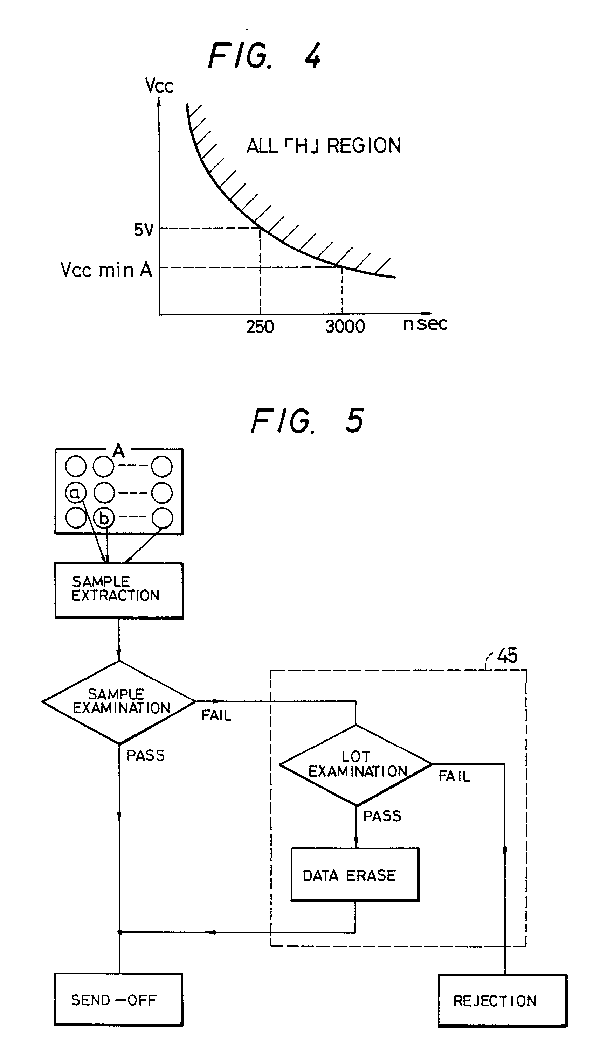

Table I shows the experimental results obtained by measuring the data erasing characteristics and a leakage current due to the irradiation of the X-rays (at 40 KV, 30 mA for 10 minutes using the Cr target) and making overall judgement. Samples Nos. 1 to 10 are those which are annealed at 170°C for 24 hours and samples Nos. 11 to 20 are those which are not annealed. The erasing characteristics are judged in the following way. Namely, the electrons are stored in the floating gates 30 of all the memory cells. That is to say, all the memory cells are in the "L" state. Next, the X-rays are irradiated to erase the data, and then $V_{cc}$ (power source voltage) is gradually raised from 0 V so that the positive potential is applied to the control gate 29 (the gate electrode 23) to render the N-MOS memory cell conductive and "H" is written into the memory cell. Then, the access time till the read-out of "H" is measured. $V_{cc}$ and the access time generally exhibit a characteristic curve such as shown in Fig. 4, and this curve is referred to as "SHMOO". In other words, since $V_{cc}$ is proportional to the control gate voltage, the higher $V_{cc}$, the higher becomes the capacity of rendering the N-MOS transistor conductive, that is, the "H" write capacity. Assuming that the data are not completely erased and the electrons remain at the floating gate, a higher $V_{cc}$ is necessary for writing "H". In other words, when the completely erased memory cell and the incompletely erased memory cell are compared with other, "H" written by the same $V_{cc}$ is weaker in the incompletely erased memory cell and hence the access time becomes much more elongated. Fig. 4 shows this, relation between $V_{cc}$ and the access time, and Table 1 illustrates the result of judgement wherein $V_{cc}$ at the access time of 3,000 ns is called $V_{ccmin}A$, and the memory cells whose $V_{ccmin}A$ is below 4.5 V are judged as accepted products having good erasing characteristics.

Incidentally, the term "leakage current" described above represents a difference current between the current value of the memory cell, to which the X-rays are irradiated, and a predetermined rated current value, as to a current that flows when a predetermined gate voltage is applied to the gate electrode of a dummy MOS device prepared on the same substrate as that of the memory cell. This current represents the degree of the X-ray damage (or the fluctuation of the threshold voltage $V_{th}$ of MOS), and the memory cells whose difference current is below 1 $\mu A$ are judged as the approved products.

Almost all the memory cells (samples Nos. 11~20) which are subjected only to the X-ray irradiation prove to be the accepted products, but their $V_{ccmin}A$ and the leakage currents exhibit greater variance than those of the samples which are subjected to the annealing treatment (samples Nos. 1~10), too. Accordingly, it can be understood that annealing is necessary in order to obtain good erasing characteristics.

Table 2

| Sample No. | erasing characteristics ($V_{ccmin}$ A) | leakage current | re-writing characteristics | data retention |
|---|---|---|---|---|
| 1 | ◯ ( 3.5 V ) | 0.0 6 μA ~ 0.0 0 μA | ◯ | ◯ |
| 2 | ◯ ( 3.5 ) | 0.0 6 ~ 0.0 0 | ◯ | ◯ |
| 3 | ◯ ( 3.5 ) | 0.0 6 ~ 0.0 0 | ◯ | ◯ |
| 4 | ◯ ( 3.5 ) | 0.0 6 ~ 0.0 0 | ◯ | ◯ |
| 5 | ◯ ( 3.5 ) | 0.0 6 ~ 0.0 0 | ◯ | ◯ |
| 6 | ◯ ( 3.5 ) | 0.0 6 ~ 0.0 0 | ◯ | ◯ |
| 7 | ◯ ( 3.5 ) | 0.0 6 ~ 0.0 0 | ◯ | ◯ |
| 8 | ◯ ( 3.5 ) | 0.0 6 ~ 0.0 0 | ◯ | ◯ |
| 9 | ◯ ( 3.5 ) | 0.0 6 ~ 0.0 0 | ◯ | ◯ |
| 1 0 | ◯ ( 3.5 ) | 0.0 6 ~ 0.0 0 | ◯ | ◯ |
| 1 1 | ◯ ( 3.5 ) | 0.0 6 ~ 0.0 0 | ◯ | ◯ |
| 1 2 | ◯ ( 3.5 ) | 0.0 6 ~ 0.0 0 | ◯ | ◯ |
| 1 3 | ◯ ( 3.5 ) | 0.0 6 ~ 0.0 0 | ◯ | ◯ |
| 1 4 | ◯ ( 3.5 ) | 0.0 6 ~ 0.0 0 | ◯ | ◯ |
| 1 5 | ◯ ( 3.5 ) | 0.0 6 ~ 0.0 0 | ◯ | ◯ |

Table 2 shows the experimental results representing the erasing characteristics, the leakage current, the rewriting characteristics and the data retention characteristcs by irradiating the X-rays - (condition: Cr target, 30 KV, 40 mA, 15 minutes) to the memory cells and annealing them at 170°C for 24 hours. All the memory cells are found to be satisfactory. The data retention characteristics represent the data retaining property of the memory cell for retaining the data written thereinto. The data retention characteristics are tested by erasing the data written into the memory cells, then rewriting the data into the memory cells and thereafter leaving them standing for a predetermined period in a predetermined heating atmoshere. Those memory cells which retain sufficiently the data, that have been rewritten thereinto, without erasing the regarded as the accepted products (o). Data retention defect means that the rewritten data are erased. The data retention characteristics are used as the scale for the stability of the written data. In Table 2, the data retention characteristics are examined by annealing the memory cells at 150°C for 48 hours.

Table 3

| Sample No. | 1st X-ray condition | confirma-tion of erasure | after annealing (170°C x 4HR) | | 2nd X-ray condition | after annealing (170°C x 24HR) | |
|---|---|---|---|---|---|---|---|
| | | | erasing charac-teristics | writing charac-teristics | | erasing charac-teristics | writing charac-teristics |
| 1 | Cr,30KV 40mA, 15 min. | o | o | o | Cr,30KV 40mA, 15 min. | o | o |
| 2 | " " , " 10 min | o | o | x | " " " 10 min. | o | o |
| 3 | , " " " 5 min. | x | x | x | " " " 10 min. | o | o |

As to the samples Nos. 1 ~ 3 in Table 3, the first X-ray irradiation is made under the condition described in the table, then first annealing is made, and after the second X-ray irradiation is made, second annealing is effected. The erasing and writing characteristics are measured at the respective stages and the memory cells are judged to be the accepted products and the defective products.

Though the satisfactory writing characteristics cannot be obtained by the first X-ray irradiation and annealing for the samples Nos. 2 and 3, they are recovered by the second X-ray irradiation and annealing.

Table 4

| Sample No. | erasing char-acteristics | writing char-acteristics |
|---|---|---|
| 1 | o | x |
| 2 | o | x |
| 3 | o | x |
| 4 | o | x |
| 5 | o | x |

Table 4 shows the result of judgement of the characteristics of the samples Nos. 1 to 5 to which the X-ray irradiation is made at 40 KV and 30 mA for 60 minutes using the Cr target and which are then subjected to annealing at 150°C for 24 hours.

Since the X-ray irradiation energy ($V^2 \times I \times T$) is too great, the X-ray damage is so great that the satisfactory writing characteristics cannot be obtained even when annealing is made.

Table 5

| annealing time | data retention |
|---|---|
| 0 hr | x |
| 2 hr | x |
| 4 hr | o |
| 24 hr | o |

Table 5 shows the test results of the data retention characteristics by irradiating the X-rays to the samples at 30 KV and 40 mA for 15 minutes using the Cr target and by changing the annealing time while the annealing temperature is fixed at 170°C. It can be understood from this table that annealing must be made for at least 4 hours in order to obtain the satisfactory data retention characteristics.

Table 6 shows the test results of the erasing characteristics of OTPROMs by irradiating the X-rays to the memory cells under the same condition as that of Table 5 and then changing the annealing time while the annealing temperature is fixed at 170°C. The satisfactory erasing characteristics can be obtained when annealing is made for 2 hours.

Table 6

| annealing time | erasing characteristics | leaking characteristics | overall judgement | $V_{CCmin}$ A | MAX leakage current |
|---|---|---|---|---|---|
| | × | × | × | 3.5 V | 2.32 μA |
| 0 HR | ○ | × | × | 3.6 | 1.76 |
| | ○ | × | × | 3.5 | .208 |
| | ○ | × | × | 3.7 | 2.04 |
| | ○ | × | × | 3.6 | 2.12 |
| | ○ | × | × | 〃 | 1.26 |
| | ○ | × | × | 〃 | 1.70 |
| 2 HR | ○ | ○ | ○ | 3.4 | 0.06 |
| | ○ | ○ | ○ | 〃 | 〃 |
| | ○ | ○ | ○ | 〃 | 〃 |
| | ○ | ○ | ○ | 3.3 | 0.04 |
| | ○ | ○ | ○ | 3.4 | 0.06 |
| | ○ | ○ | ○ | 〃 | 0.08 |
| | ○ | ○ | ○ | 〃 | 0.06 |
| 4 HR | ○ | ○ | ○ | 〃 | 0.04 |
| | ○ | ○ | ○ | 〃 | 〃 |
| | ○ | ○ | ○ | 〃 | 〃 |
| | ○ | ○ | ○ | 〃 | 〃 |
| | ○ | ○ | ○ | 3.5 | 〃 |
| | ○ | ○ | ○ | 〃 | 〃 |
| | ○ | ○ | ○ | 3.4 | 〃 |
| 8 HR | ○ | ○ | ○ | 〃 | 〃 |
| | ○ | ○ | ○ | 3.3 | 0.02 |
| | ○ | ○ | ○ | 3.4 | 〃 |
| | ○ | ○ | ○ | 〃 | 〃 |
| | ○ | ○ | ○ | 〃 | 0.04 |
| | ○ | ○ | ○ | 〃 | 〃 |
| | ○ | ○ | ○ | 3.5 | 0.02 |

The following features can be understood from the experiments described above.

(1) An optimum range exists for the X-ray irradiation energy, and is considerably wide (e.g. - (1) 40 KV, 30 mA, 10 to 15 min.; (2) 35 KV, 15 mA, 20 to 25 min.).

(2) An optimum range exists for the annealing condition, too. The experiments carried out by the inventors of the present invention represent that the lowest temperature that provides the stable characteristics is about 125°C while the upper limit is about 220°C in view of the heat-resistance of the IC packaging material, and more preferably from 170°C to 220°C. Annealing is effected preferably for at least 4 hours in order to prevent the occurrence of the data retention defect.

(3) The X-rays generated by use of the Cr target provide the satisfactory erasing characteristics and the writing characteristics. Target selection is of importance in order to decide the ray quality of the X-rays. Therefore, the conditions that must be taken into consideration for selecting the target will be explained briefly.

Namely, the X-rays must satisfy the requirements, i.e. (1) they must have energy such that they can pass through the molding member and reach the chip, but (2) they have an optimal energy value so that they do not impart excessive damage to the chip. The X-rays consist of continuous X-rays and characteristics X-rays. The shorter the wavelength, the higher becomes the material transmission effect of the X-rays and the greater becomes the X-ray damage of the member to which the X-rays are irradiated. On the other hand, the longer the wavelength, the lower the transmission effect, so that the X-rays will be absorbed by the resin package and the like and cannot sufficiently reach the chip.

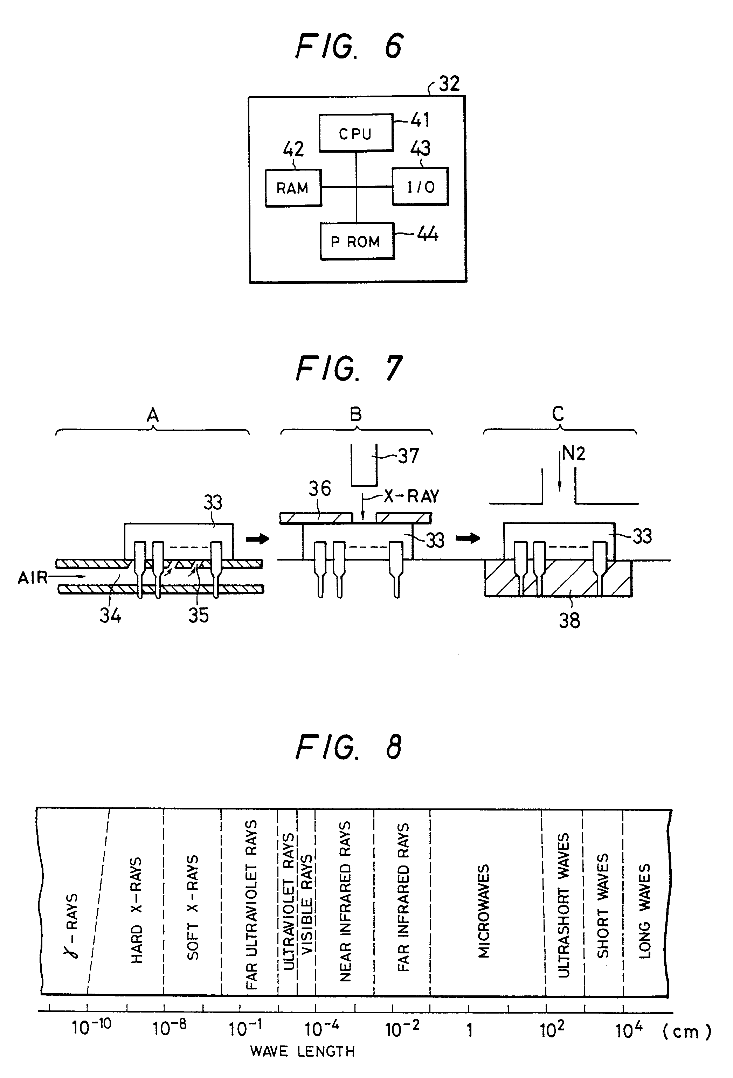

Fig. 8 shows the classification of electromagnetic waves in accordance with their wavelengths. In order to satisfy the requirements described above, the X-rays to be used are preferably in the range of soft X-rays. In terms of the wavelength of the characteristics X-rays, the wavelengths $K\alpha_1$ and $K\alpha_2$ of the characteristics X-rays of Cr used for the experiments described already are from 0.2 to 0.3 nm. If carbon C is used in place of the Cr target, for example, the wavelength of the resulting X-rays is so long that the X-rays are absorbed by the resin package and cannot sufficiently reach the chip. If tungsten (W) is used, for example, the wavelength $K\alpha_1$ and $K\alpha_2$ of the resulting characteristic X-rays are about 0,021 nm and are within the range of hard X-rays. Therefore, the wavelength of the X-rays is so short that damge to the memory chip - (memory chip itself and its peripheral circuits) will be too great. Thus, the X-ray target must be selected carefully.

In short, the present invention irradiates the low energy X-rays (soft X-rays for a short period of at most about 30 minutes) and thereafter (or simultaneously) recovers the X-ray damage by thermal excitation.

Next, the effects of the first embodiment will be described.

First of all, erasing and rewriting of the data for OTPROM can be amde. As a result, inspection accuracy as well as production yield can be improved. In accordance with the prior art, all the product of a lot A are discarded if any defective products sampled from the lot are found in the lot. In accordance with the present invention, however, it is possible to add a step 45 (encircled by dotted line) in Fig. 5, and the accepted products which reliably pass the data writing characteristics test can be shipped. In other words, if any samples are found defective in the sampling test (sample examination) after extraction of the samples, the products of that lot are subjected once to the write and read tests (lot inspection, lot examination, total inspection), and only those products which are surely judged as defective are discarded while the data of the rest of the products are erased in accordance with the present method and the products are then shipped.

Embodiment 2

The present invention can be applied not only to OTPROM but also to single chip microcomputer with built-in PROMs. The single chip microcomputer comprises of CPU 41, RAM 42, I/0 port 43 and PROM 44 as shown in Fig. 6, and is molded by plastics or the like. The inventors of the present invention conducted the experiments by irradiating the X-rays to the single chip microcomputer and then annealing it.

The experimental condition is the same as described already, and the experiment is effected so that the X-rays are concentrated on the PROM portion. The result is found to be extremely satisfactory in the same way as in the case of OTPROM. Table 7 shows examples of the results.

Table 7

| Sample No. | X-ray condition | erasing characteristics after annealing |
|---|---|---|
| 1 | 30KV, 40mA 15 min. | o |
| 2 | " | o |
| 3 | " | o |
| 4 | " | o |
| 5 | " | o |
| 6 | " | o |

Embodiment 3

The present invention can be practiced by use of a through-process apparatus without any labor if the necessary conditions are satisfied. Fig. 7 shows an example of such an apparatus. An automatic transfer machine using an air conveyor transfers ICs to a portion B, then brings a mask 36 into close contact with each IC and thereafter irradiates the X-rays to only the necessary portions of the IC. Next, annealing treatment is carried out by utilizing a heat block 38 and a hot jet to recover the X-ray irradiation damage. As a result, data erasure of PROM can be made reliably for single chip microcomputers, and the like.

**Claims**

1. A data processing method comprising the steps of:
(1) storing data in memory means (7) of an electronic device having said memory means (7) and a molding member (8) for molding said memory means (7); and
(2) erasing said data stored in said memory means (7); wherein said data erasing step includes X-ray irradiation treatment and heat-treatment.

2. The method of claim 1, wherein said molding member (8) comprises a resin and covers said memory means (7).

3. The method of claim 1 or 2, wherein said X-ray irradiation treatment is effected from outside said molding member (8).

4. The method of any of claims 1 to 3, wherein said X-ray irradiation treatment is effected by use of soft X-rays.

5. The method of any of claims 1 to 4, wherein said X-ray irradiation treatment is effected by use of X-rays having a wavelength greater than several tenths of a nanometer.

6. The method of claim 5, wherein the irradiation time of said X-rays is less than 60 minutes.

7. The method of any of claims 1 to 6, wherein said X-ray irradiation treatment of the electronic device is effected for 10 to 25 minutes, the X-rays being generated by impinging electrons accelerated at a voltage of 30 KeV to 40 KeV and a current of 30 mA to 40 mA onto a chromium target.

8. The method of any of claims 1 to 7, wherein said heat-treatment of the electronic device is effected at a temperature in the range of 125°C to 220°C to minimize any influences of a hole of a hole-electron pair resulting from the X-ray irradiation of said memory means (7).

9. The method of claim 8, wherein said heat-treatment is effected for at least 4 hours.

10. The method of any of claims 1 to 9, wherein said heat-treatment is effected in an atmosphere of a relative humidity from 40% to 50%.

11. The method of any of claims 1 to 10, wherein said heat-treatment is effected in a non-oxidizing atmosphere.

# FIG. 1

X-RAYS IRRADIATION

HEAT TREATMENT

N₂ (OR AIR)

ROM WRITE

REWRITE

# FIG. 2

$O_0 \sim O_7$

PGM  ○
OE   ○
CE   ○

16 — POWER DOWN PROG LOGIC

OUTPUT BUFFER — 19

17 — Y-DECODER

Y-GATIG — 20

$A_0$
$\sim$
$A_{12}$

X-DECODER

65536 BIT MEMORY MATRIX — 21

18

# FIG. 3

S          G          D
○          ○          ○

29  23        24

22

31

30

n+        n+

25    27  P  30    26    28

P  30

P-Sub (Si)

# FIG. 4

Vcc

ALL 「H」REGION

5V

Vcc min A

250    3000    n sec

# FIG. 5

A

ⓐ
ⓑ

SAMPLE
EXTRACTION

SAMPLE
EXAMINATION — FAIL

PASS

45

LOT
EXAMINATION — FAIL

PASS

DATA ERASE

SEND —OFF

REJECTION

## FIG. 6

## FIG. 7

## FIG. 8

WAVE LENGTH